Europäisches Patentamt

European Patent Office

Office européen des brevets

(11) Veröffentlichungsnummer: **0 468 382 A1**

# EUROPÄISCHE PATENTANMELDUNG

(21) Anmeldenummer: **91112152.3**

(51) Int. Cl.5: **H01L 31/0224**

(22) Anmeldetag: **20.07.91**

(30) Priorität: **24.07.90 DE 4023495**

(43) Veröffentlichungstag der Anmeldung:
**29.01.92 Patentblatt 92/05**

(84) Benannte Vertragsstaaten:
**AT BE CH DE DK ES FR GB GR IT LI LU NL SE**

(71) Anmelder: **Nukem GmbH**
**Industriestrasse 13**
**W-8755 Alzenau(DE)**

(72) Erfinder: **Buss, Werner**
**Wilhelm-Leuschner-Strasse 8**
**W-6450 Hanau 8(DE)**
Erfinder: **Ebinger, Horst**
**Buchstrasse 7**
**W-6483 Salmünster(DE)**
Erfinder: **von Campe, Hilmar, Dr.**
**Jakob-Lengenfelder-Strasse 19**
**W-6380 Bad Homberg(DE)**
Erfinder: **Warzawa, Wolfgang**
**Wiesenstrasse 15**
**W-6450 Hanau 9(DE)**

(74) Vertreter: **Stoffregen, Hans-Herbert, Dr.**
**Dipl.-Phys.**
**Patentanwalt, Salzstrasse 11 a, Postfach 21**
**44**
**W-6450 Hanau (Main) 1(DE)**

(54) **Elektrisch leitfähiges Material für Solarzelle.**

(57) Es wird ein elektrisch leitfähiges Material insbesondere bestimmt für ein elektronisches Bauelement vorgeschlagen, das eine Aluminium-Bor-Verbindung als elektrisch leitfähiges Material enthält. Auch werden Verfahren angegeben, um entsprechende elektrisch leitfähige Materialien herzustellen.

EP 0 468 382 A1

Die Erfindung bezieht sich auf ein elektronisches Bauelement, insbesondere Solarzelle, mit einem aus elektrisch leitfähigem Material bestehenden Kontakt. Ferner bezieht sich die Erfindung auf ein Verfahren zur Herstellung eines elektrisch leitfähigen Materials, insbesondere zur Verwendung als Kontakt eines elektrischen Bauelementes wie Solarzelle.

Als elektrisch leitfähige keramische Materialien sind Boride, Nitride, Carbide der Metalle Chrom, Hafnium, Lanthan, Molybdän, Niob, Tantal, Titan, Vanadium, Wolfram und Zirkon bekannt.

So wird z.B. TiN (Titannitrid) aufgrund seiner goldähnlichen Färbung, die auf der Reflektion des Lichtes durch das Elektronengas beruht, als Ersatzmaterial für Gold im Bereich dekorativer Beschichtungen eingesetzt.

$TiB_2$ (Titandiborid) ist ein hoch leitfähiges Material, das aufgrund seiner Kristallstruktur und chemischen Bindung eine hohe Härte besitzt, d. h., im mechanischen Verhalten eher einer Keramik als einem Metall ähnlich ist.

Diese Materialien, insbesondere die Boride und Carbide, weisen darüber hinaus eine hohe Temperaturstabilität auf, die sie als Kontaktmaterial für elektronische Bauelemente wie Solarzellen aus Silizium geeignet erscheinen lassen, wenn eine hohe Temperatur zu deren Herstellung erforderlich ist und während der Herstellung bei hoher Temperatur beide Materialien in Berührung kommen.

Zum Beispiel kann $TiB_2$ als elektrisch leitfähiges Substrat für Silizium-Solarzellen eingesetzt werden. Dabei wird Silizium auf das Substrat bei Temperaturen über 1000 °C aufgedampft.

Im Gegensatz zu einer Beschichtung von Metallen bei diesen hohen Temperaturen weisen Verbindungen wie Boride, Carbide und Nitride eine geringere chemische Reaktionsgeschwindigkeit mit Silizium bei entsprechenden Temperaturen auf. Dennoch kann nicht ausgeschlossen werden, daß geringe Mengen des Metalles -wie z.B. Chrom, Titan, Molybdän, Wolfram, Zirkonium- aus der Verbindung herausgelöst werden und in das Silizium eindiffundieren, wobei die Diffusionsgeschwindigkeit exponentiell mit der Temperatur zunimmt. Besonders an Korngrenzen des Siliziums wird die Diffusionsgeschwindigkeit sehr groß.

Werden die Metallatome in das Kristallgitter eingebaut, so wirken sie meistens als Rekombinationszentren, die die Eigenschaften des herzustellenden Bauelementes negativ beeinflussen. Insbesondere die zuvor angesprochenen Schwermetalle besitzen dabei bereits in geringen Konzentrationen (ppb-Bereich) diese nachteilige Wirkung.

Hierdurch bedingt zeigen Silizium-Solarzellen, bei denen Silizium-Schichten auf $TiB_2$-Schichten aufgebracht sind, nur einen sehr geringen Wirkungsgrad.

Aufgabe der vorliegenden Erfindung ist es, ein elektronisches Bauelement bzw. ein Verfahren zur Herstellung eines elektrisch leitfähigen Materials bzw. dieses selbst zur Verfügung zu stellen, das die dem Bestimmungszweck entsprechende elektrische Leitfähigkeiten aufweist und eine hinreichende mechanische Stabilität zeigt, ohne daß insbesondere bei einer Verwendung bei elektronischen Bauelementen wie Solarzellen die Gefahr besteht, daß die Bauelemente selbst von ihren Eigenschaften her nachteilig beeinflußt werden.

Bei einem elektronischen Bauelement wird die Aufgabe im wesenlichen dadurch gelöst, daß der Kontakt zumindest eine elektrisch leitfähige Aluminium-Bor-Verbindung, insbesondere $AlB_2$ enthält.

Letzteres kann als elektrisch leitfähiges Material nach einer Vielzahl von Verfahren hergestellt werden. Insoweit wird auf die Ansprüche verwiesen.

Im übrigen sind den Ansrpüchen eine Vielzahl von Merkmalen - für sich und/oder in Kombination - zu entnehmen, durch die die Erfindung geprägt wird.

Das erfindungsgemäß als elektrisch leitfähiges Material vorgeschlagene Aluminium-Borid wie insbesondere Aluminiumdiborid kann problemlos als Kontaktmaterial zu Silizium verwendet werden. Im Gegensatz zu den Schwermetallen bilden die Elemente Aluminium und Bor im Silizium flache Störstellen. Sie wirken als Elektronenakzeptoren und werden zur p-Dotierung eingesetzt. Bei der Herstellung von Solarzellen mit pn-Übergang und von MIS-Inversionsschichtsolarzellen wird p-leitendes (Bor-dotiertes) Silizium als Grundmaterial eingesetzt.

Die Herstellung des Grundmaterials Silizium kann in einem kostengünstigen Prozeß erfolgen, sofern polykristalline Silizium-Schichten mit Hilfe des CVD- (Chemical Vapor Deposition) Verfahrens oder des Wachstums aus einer siliziumhaltigen Lösung auf billigen Fremdsubstraten abgeschieden werden.

Sofern diese Substrate Isolatoren sind, ist auch eine elektrische Serienschaltung der Solarzellen möglich. Letzteres kann jedoch nur dann realisiert werden, wenn vor der Abscheidung der polykristallinen Silizium-Schicht ein Rückkontakt auf dem Substrat aufgebracht wird.

Wenn die Abscheidung von Silizium bei hohen Temperaturen erfolgt -ein Erfordernis zur Herstellung polykristalliner Siliziumschichten-, können reine Metallschichten nicht als Rückkontakt zum Einsatz gelangen, da andernfalls Legierungen mit Silizium entstehen würden.

Elektrisch leitfähige Verbindungen sind dagegen länger stabil, wenngleich nicht vermieden werden kann, daß sich geringe Mengen dieser durch Diffusion in Silizium einbauen. Insofern ist die Verwendung von Materialien wie $TiB_2$ nachteilig, da bereits sehr geringe Titankonzentrationen von $10^{13} cm^{-3}$ ausreichen, um eine Solarzelle nachhaltig zu schädigen. Diese Mengen bauen sich bei der Abscheidung der polykristallinen Schicht bei hohen Temperaturen ein.

Um all diese Nachteile zu umgehen, wird erfindungsgemäß eine elektrisch leitfähige insbesondere keramische Verbindung aus den Elementen Aluminium und Bor vorgeschlagen, wobei diese Elemente, wenn sie in geringen Mengen in Silizium eindiffundiert sind, nicht als Rekombinationszentren, durch die der Wirkungsgrad der Solarzelle negativ beeinflußt wird, eingebaut werden, sondern als Akzeptoren, die eine zusätzliche Dotierung des ohnehin p-leitenden Siliziums verursachen.

Da eine Bor-Dotierung (oder äquivalente Aluminium-Dotierung) von ca. $10^{17} cm^{-3}$ dieser Schichten erforderlich ist, kann eine wesentlich höhere Konzentration von Dotiermaterial im Vergleich zu der zulässigen Titankonzentration von $10^{13} cm^{-3}$ akzeptiert werden.

Um elektrisch leitendes Keramikmaterial aus Aluminium und Bor wie $AlB_2$ herzustellen, kann vorzugsweise handelsübliches $AlB_2$-Pulver von beispielsweise 200 mesh Partikelgröße mit einer Kraft von 20 t verpreßt werden.

Eine weitere Möglichkeit zur Herstellung besteht darin, daß $AlB_2$-Pulver durch Sintern in eine noch dichtere Struktur gebracht wird, wodurch die Leitfähigkeit des Materials erheblich zunimmt. Bevorzugte Sintertemperaturen liegen dabei zwischen 600°C und 1450°C.

Nach einem weiteren Vorschlag kann AlBx, insbesondere $AlB_2$-Pulver in einen organischen Binder eingebracht werden, um mit diesem in eine gewünschte Form übergeführt zu werden. Anschließend wird durch Trocknen des Bindemittels, anschließendes Verbrennen und Sintern ein keramischer formstabiler Körper gewonnen, der die gewünschte elektrische Leitfähigkeit besitzt.

Bevorzugterweise kann das elektrisch leitfähige Material in Form AlBx, insbesondere $AlB_2$ in Schichtform hergestellt werden, in denen gasförmige Komponenten in Form von $AlCl_3$ und $BCl_3$ bei Temperaturen von vorzugsweise zwischen 800°C bis 1500°C mit Wasserstoff reduziert werden, wobei sich vorzugsweise stöchiometrisches $AlB_2$ abscheidet.

So ist es nach einer Ausgestaltung der Erfindung möglich, ein Substrat wie Glas, Keramik oder Graphit mit einem geeigneten Erwärmer wie Strahlungsheizung, Hochfrequenzheizung, Heizung durch direkten Stromdurchgang oder Heizen im inneren eines Widerstandsofens bei Temperaturen von vorzugsweise 800°C bis 1500°C durch Reduktion von $AlCl_3$ und $BCl_3$ mit Wasserstoff zu

beschichten, um gewünschte leitfähige Materialien in Form von einer Aluminium-Bor-Verbindung wie $AlB_2$ zu erhalten.

AlBx wie $AlB_2$ kann auch durch Aufdampfen aus einem Schiffchen, aus zwei Verdampferquellen oder durch Flash-Verdampfung hergestellt werden.

Eine andere Möglichkeit besteht darin, durch Kathodenzerstäubung eines heißgepreßten $AlB_2$-Targets eine $AlB_2$-Schicht herzustellen.

Nach einem weiteren Vorschlag der Erfindung ist vorgesehen, eine Aluminiumschmelze mit gasförmigem $BCl_3$ in Verbindung zu bringen, so daß auf der Kontaktfläche das gasförmige $BCl_3$ mit dem Aluminium reagiert. $AlB_3$ ist bei Temperaturen zwischen 700°C bis 1350°C in Aluminiumschmelze löslich. Durch ausreichend langen und intensiven Kontakt zwischen $BCl_3$ und der Aluminiumschmelze wird die Lösung mit $AlB_2$ gesättigt. Beim Abkühlen der Lösung scheidet sich $AlB_2$ in kristalliner Form an der kältesten Stelle aus der Lösung aus.

Anstelle einer Unterkühlung kann auch eine Übersättigung erfolgen, indem die Lösung in einem ersten Bereich kälter als in einem zweiten gehalten wird, in dem $AlB_2$ in Lösung geht. Dadurch wird die Lösung in dem kälteren Bereich übersättigt und infolgedessen scheidet sich $AlB_2$ aus.

In Ausgestaltung dieses Verfahrensvorschlages wird ein Substrat mit dem Aluminium derart in Kontakt gebracht, daß das Substrat vorzugsweise 1°C bis 100°C kälter ist als die Schmelze, wobei sich eine $AlB_2$-Schicht oder $AlB_2$-Kristalle auf dem Substrat abscheiden.

Mit den zuvor angegebenen Verfahren kann ein Substrat mit $AlB_2$ oder einer Verbindung, die Aluminium und Bor enthält, beschichtet werden. Die Schicht bildet einen elektrisch leitfähigen Überzug, der als Elektrode oder Kontaktmaterial geeignet ist. Wird ein isolierendes Substrat mit einer elektrisch leitfähigen Schicht aus $AlB_2$ oder einer anderen Aluminium-Bor-Verbindung beschichtet, so ist diese Schicht wiederum geeignet, mit polykristallinem Silizium bei hohen Temperaturen beschichtet zu werden, ohne daß die Silizium-Schicht durch Einbau tiefer Störstellen geschädigt wird.

**Patentansprüche**

1. Elektronisches Bauelement, insbesondere Solarzelle, mit einem aus elektrisch leitfähigem Material bestehenden Kontakt,
   **dadurch gekennzeichnet,**
   daß der Kontakt zumindest eine elektrisch leitfähige Aluminium-Bor-Verbindung enthält.

2. Elektronisches Bauelement nach Anspruch 1,
   **dadurch gekennzeichnet,**
   daß die Aluminium-Bor-Verbindung Aluminium-

borid, insbesondere AlB$_2$ ist.

3. Verfahren zur Herstellung elektrisch leitfähigen Materials, insbesondere zur Verwendung als Kontakt eines elektronischen Bauelementes wie Solarzelle,
**dadurch gekennzeichnet,**
daß insbesondere durch mechanische und/oder chemische Beeinflussung von zumindest Aluminium und Bor enthaltenden oder aus diesen bestehenden Materialien eine elektrisch leitfähige Aluminium-Bor-Verbindung hergestellt wird.

4. Verfahren nach Anspruch 3,
**dadurch gekennzeichnet,**
daß ein eine Aluminium-Bor-Verbindung enthaltendes pulverförmiges Material zu dem elektrisch leitfähigen Material umgewandelt wird.

5. Verfahren nach Anspruch 4,
**dadurch gekennzeichnet,**
daß das pulverförmige Material in Form von Aluminium-Borid wie AlB$_2$ unter hohem Druck zu einem formstabilen Körper verpreßt wird, daß vorzugsweise der Körper nach dem Verpressen und/oder während des Verpressens bei einer Temperatur von vorzugsweise zwischen 600°C und 1450°C gesintert wird.

6. Verfahren nach Anspruch 3,
**dadurch gekennzeichnet,**
daß Aluminiumborid wie AlB$_2$ enthaltendes pulverförmiges Material oder Aluminiumborid- wie AlB$_2$-Pulver mit einem organischen Bindemittel homogen vermischt wird, die so gewonnene Mischung in eine gewünschte Form gebracht wird, die ihrerseits durch Trocknen bei einer Temperatur von vorzugsweise bis 300°C in einen formstabilen Körper überführt und dieser anschließend durch Wegbrennen organischer Komponenten bei einer Temperatur oberhalb der zum Trocknen, vorzugsweise oberhalb 300°C in einem Gas wie Luft in eine Sinterkeramik umgewandelt wird.

7. Verfahren nach Anspruch 3,
**dadurch gekennzeichnet,**
daß Aluminiumborid wie AlB$_2$ enthaltende, insbesondere flexible Keramikfolien durch Verbrennen organischer Bestandteile wie Bindemittel und Sintern in ein keramisch plattenförmiges Element oder eine keramische Schicht als das elektrisch leitfähige Material umgewandelt wird.

8. Verfahren nach Anspruch 3,

**dadurch gekennzeichnet,**
daß mittels CVD zur Bildung von Aluminiumborid wie AlB$_2$ gasförmiges AlCl$_3$ und BCl$_3$ an einem heißen Substrat mit Wasserstoffgas reduziert werden.

9. Verfahren nach Anspruch 3,
**dadurch gekennzeichnet,**
daß Aluminiumborid - wie AlB$_2$-Pulver - aus einem Verdampferschiffchen mittels thermischer Verdampfung oder Flash-Verdampfung oder thermischer Verdampfung aus zwei zum einen Aluminium und zum anderen Bor enthaltenden Verdampferschiffchen auf ein Substrat aufgedampft wird.

10. Verfahren nach Anspruch 3,
**dadurch gekennzeichnet,**
daß mittels Kathodenzerstäubung eines heißgepreßten Alumiumborid-Targets das elektrisch leitfähige Material in Form von Aluminiumborid, insbesondere AlB$_2$ hergestellt wird.

11. Verfahren nach Anspruch 3,
**dadurch gekennzeichnet,**
daß gasförmiges BCl$_3$ mit einer heißen Aluminiumschmelze derart in Kontakt gebracht wird, daß sich an der Kontaktfläche krustenförmiges Aluminiumborid wie AlB$_2$ ausbildet, daß sich nach und nach in der Aluminiumschmelze eine gesättigte Lösung von Aluminiumborid bildet und daß anschließend durch Abkühlen der Schmelze in zumindest einem Bereich der Aluminiumschmelze eine Übersättigung von Aluminiumborid und hierdurch bedingtes Ausscheiden von diesem erfolgt.

12. Elektrisch leitfähiges Material, insbesondere zur Verwendung als Elektrode für z. B. ein elektronisches Bauelement wie Solarzelle,
**dadurch gekennzeichnet,**
daß das elektrisch leitfähige Material eine Verbindung aus Aluminium und Bor vorzugsweise Aluminiumborid wie AlB$_2$ enthält.

Europäisches
Patentamt

**EUROPÄISCHER
RECHERCHENBERICHT**

Nummer der Anmeldung

**EP 91 11 2152**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | SOLID STATE ELECTRONICS. Bd. 32, Nr. 5, Mai 1989, OXFORD GB Seiten 385 - 389; T.LARSSON ET AL.: 'Si/Ti/TiB2/Al STRUCTURES INVESTIGATED AS CONTACTS IN MICROELECTRONIC DEVICES' * das ganze Dokument * * — — — | 1-12 | H 01 L 31/0224 |
| A | THIN SOLID FILMS. Bd. 90, Nr. 4, April 1982, LAUSANNE CH Seiten 461 - 471; C.FELDMAN ET AL.: 'VACUUM DEPOSITED POLYCRISTALLINE SILICON SOLAR CELLS ON FOREIGN SUBSTRATES' * Seite 461, Zeile 1 - Seite 463, Zeile 26; Abbildung 1 * * — — — | 1-12 | |
| A | PATENT ABSTRACTS OF JAPAN vol. 8, no. 161 (E-257)(1598) 26. Juli 1984 & JP-A-59 061 129 ( FUJITSU K.K. ) 7. April 1984 * Zusammenfassung * * — — — | 1,2,12 | |
| A | PATENT ABSTRACTS OF JAPAN vol. 13, no. 279 (P-891)27. Juni 1989 & JP-A-01 068 762 ( RICOH CO LTD ) 14. März 1989 * Zusammenfassung * * — — — | 1,12 | RECHERCHIERTE SACHGEBIETE (Int. Cl.5) |
| A | PATENT ABSTRACTS OF JAPAN vol. 11, no. 176 (C-426)5. Juni 1987 & JP-A-62 001 834 ( KOBE STEEL LTD ) 7. Januar 1987 * Zusammenfassung * * — — — | 3 | H 01 L |
| A | PATENT ABSTRACTS OF JAPAN vol. 13, no. 141 (P-853)7. April 1989 & JP-A-63 306 484 ( SHOWA ALUM CORP ) 14. Dezember 1988 * Zusammenfassung * * — — — — — | 1 | |

Der vorliegende Recherchenbericht wurde für alle Patentansprüche erstellt

| Recherchenort | Abschlußdatum der Recherche | Prüfer |
|---|---|---|
| Den Haag | 07 November 91 | LINA F. |

**KATEGORIE DER GENANNTEN DOKUMENTE**
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus anderen Gründen angeführtes Dokument
-----------------------------------------------------------------
& : Mitglied der gleichen Patentfamilie, übereinstimmendes Dokument